# EUROPEAN PATENT APPLICATION

(11) **EP 4 001 978 A1**
(43) Date of publication of application: **25.05.2022**
(21) Application number: 20843281.5
(22) Date of filing: 16.03.2020
(51) Int. Cl.: G02B 6/122

(54) **OPTICAL WAVEGUIDE, OPTICAL WAVEGUIDE WITH ADHESIVE LAYER, OPTICAL WIRING COMPONENT AND ELECTRONIC DEVICE**

(30) Priority: 19.07.2019 JP 2019133594
(71) Applicant: Sumitomo Bakelite Co.Ltd., Shinagawa-ku Tokyo 140-0002 (JP)
(72) Inventor: KINOSHITA, Ryota, Tokyo 140-0002 (JP); IMAI, Hirotake, Tokyo 140-0002 (JP)
(74) Representative: Ter Meer Steinmeister & Partner
(86) International application number: PCT/JP2020/011468
(87) International publication number: WO 2021/014680

(57) **Abstract**

According to the present invention, an optical waveguide includes a core layer having a first surface and a second surface having a front and back relationship with each other, the core layer including a core portion extending along a core axis and a side clad portion, a first cover layer provided on the first surface, the first cover layer having an adhesive surface on an opposite side of the core layer, and a second cover layer provided on the second surface, the second cover layer having an opposite surface on an opposite side of the core layer. The optical waveguide has a sheet shape and has a first recess portion that is open to the adhesive surface. When the adhesive surface is viewed in plan view, the first recess portion includes a first groove extending along a first axis that intersects with the core axis. The optical waveguide is used by being adhered to an adhesion target via an adhesive layer in contact with the adhesive surface.

## Description

### Technical Field

The present invention relates to an optical waveguide, an optical waveguide with an adhesive layer, an optical wiring component, and an electronic device.

### Background Art

An optical waveguide may be used in a state of being stuck to any adhesion target via an adhesive. For example, in PTL 1, an optical waveguide unit is adhered to an electric circuit unit via an adhesive. This enables surface mounting of an optical wiring on an electric circuit board. As a result, for example, it is possible to construct a device capable of optical transmission and having a low profile.

### Citation List

### Patent Literature

[PTL 1] JP 2012-194401 A

### Summary of Invention

### Technical Problem

However, because the optical waveguide having a sheet shape has a large adhesion area, it is difficult to stick the optical waveguide to correspond to an adhesion target. For example, in a case where the surface of the adhesion target includes a curved surface, if the shape followability of the optical waveguide is low, a gap is likely to occur between the adhesion target and the optical waveguide. This gap causes a decrease in adhesive strength.

An object of the present invention is to provide an optical waveguide enabled to be stuck to an adhesion target with a high close-adhesion property, an optical waveguide with an adhesive layer, an optical wiring component, and an electronic device having high reliability.

### Solution to Problem

Such an object is achieved by the present invention of (1) to (12) as follows.
(1) An optical waveguide including:
   a core layer having a first surface and a second surface having a front and back relationship with each other, the core layer including a core portion extending along a core axis and a side clad portion,
   a first cover layer provided on the first surface, the first cover layer having an adhesive surface on an opposite side of the core layer, and
   a second cover layer provided on the second surface, the second cover layer having an opposite surface on an opposite side of the core layer,
   in which the optical waveguide has a sheet shape,
   the optical waveguide has a first recess portion that is open to the adhesive surface,
   when the adhesive surface is viewed in plan view, the first recess portion includes a first groove extending along a first axis that intersects with the core axis, and
   the optical waveguide is used by being adhered to an adhesion target via an adhesive layer in contact with the adhesive surface.
(2) The optical waveguide described in (1), in which a bottom of the first recess portion is located in the first cover layer.
(3) The optical waveguide described in (1) or (2), in which a depth of the first groove is 20% to 80% of a thickness of the first cover layer.
(4) The optical waveguide described in (3), in which a width of the first groove is 0.2 to 5.0 times the depth of the first groove.
(5) The optical waveguide described in any one of (1) to (4), in which, when the adhesive surface is viewed in the plan view, the first recess portion further includes a second groove extending along a second axis that intersects with the first axis.
(6) The optical waveguide described in any one of (1) to (5), further including: a second recess portion that opens on the opposite surface of the second cover layer.
(7) The optical waveguide described in any one of (1) to (6), in which elastic moduli of the first cover layer and the second cover layer is greater than an elastic modulus of the core layer.
(8) The optical waveguide described in any one of (1) to (7), further including: a first clad layer provided between the core layer and the first cover layer, and
   a second clad layer provided between the core layer and the second cover layer.
(9) An optical waveguide with an adhesive layer, the optical waveguide including:
   the optical waveguide described in any one of (1) to (8), and
   an uncured adhesive layer provided on the adhesive surface of the optical waveguide.
(10) The optical waveguide with an adhesive layer described in (9), in which the first recess portion of the optical waveguide forms a cavity.
(11) An optical wiring component including: the optical waveguide described in any one of (1) to (8).
(12) An electronic device including:
   an adhesion target,
   the optical waveguide described in any one of (1) to (8), and
   an adhesive layer provided between the adhesion target and the adhesive surface of the optical waveguide.

### Advantageous Effects of Invention

According to the present invention, it is possible to obtain an optical waveguide enabled to be stuck to an adhesion target with a high close-adhesion property, an optical waveguide with an adhesive layer, and an optical wiring component.

According to the present invention, it is possible to obtain an electronic device having high reliability.

### Brief Description of Drawings

FIG. 1 is a plan view illustrating an optical waveguide according to a first embodiment.
FIG. 2 is a partially enlarged perspective view of the optical waveguide illustrated in FIG. 1.
FIG. 3 is a cross-sectional view taken along line A-A of the optical waveguide illustrated in FIG. 1 and a diagram for explaining a method of using the optical waveguide.
FIG. 4 is a diagram illustrating a state in which the optical waveguide is stuck to an adhesion target by the use method illustrated in FIG. 3.
FIG. 5 is a diagram illustrating a state in which the optical waveguide is stuck to the adhesion target by the use method illustrated in FIG. 3.
FIG. 6 is a cross-sectional view of an optical waveguide according to a first modification example of the first embodiment.
FIG. 7 is a cross-sectional view of an optical waveguide with an adhesive layer according to a second modification example of the first embodiment.
FIG. 8 is a cross-sectional view of an optical waveguide according to a third modification example of the first embodiment.
FIG. 9 is a cross-sectional view of an optical waveguide according to a fourth modification example of the first embodiment.
FIG. 10 is a cross-sectional view of an optical waveguide according to a fifth modification example of the first embodiment.
FIG. 11 is a partially enlarged perspective view of an optical waveguide according to a second embodiment.
FIG. 12 is a cross-sectional view of an optical waveguide according to a third embodiment.

### Description of Embodiments

Hereinafter, an optical waveguide, an optical waveguide with an adhesive layer, an optical wiring component, and an electronic device according to the present invention will be described in detail based on the preferred embodiments illustrated in the accompanying drawings.

### 1. First Embodiment

First, an optical waveguide according to a first embodiment will be described.

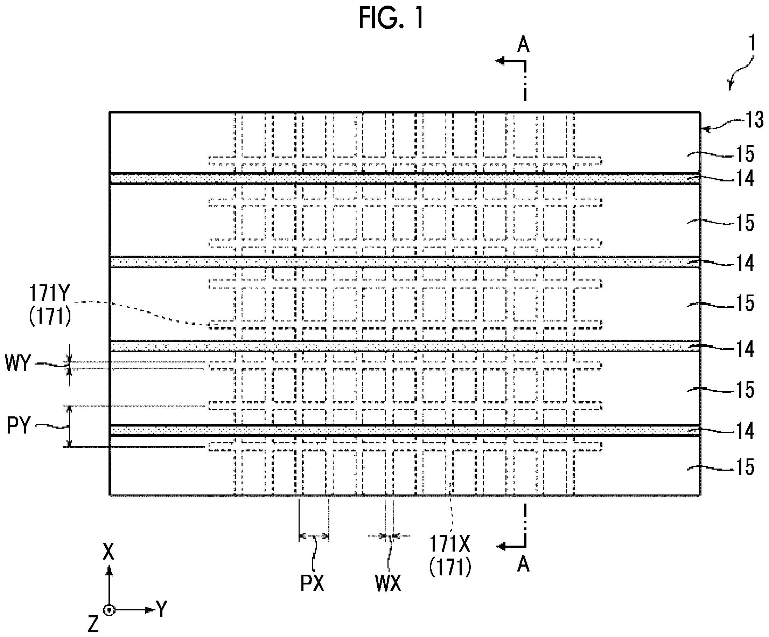

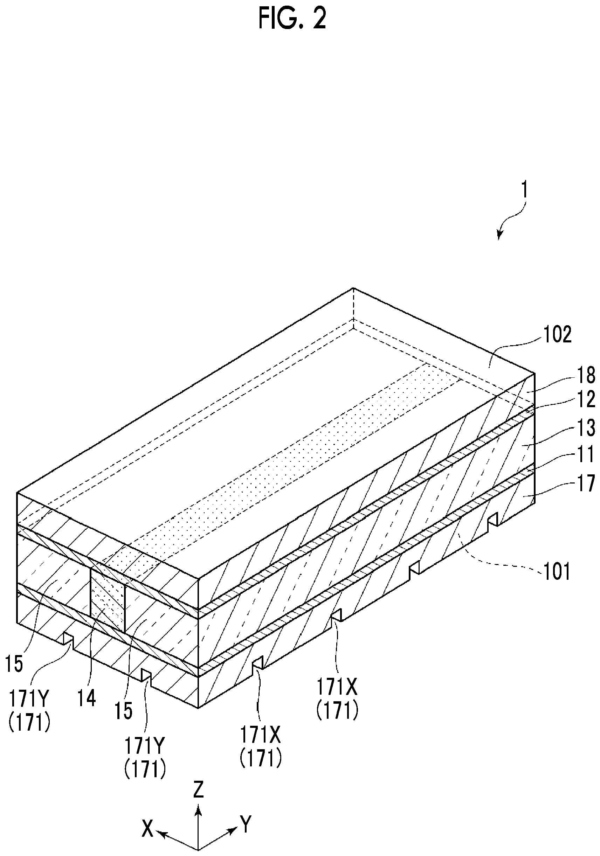

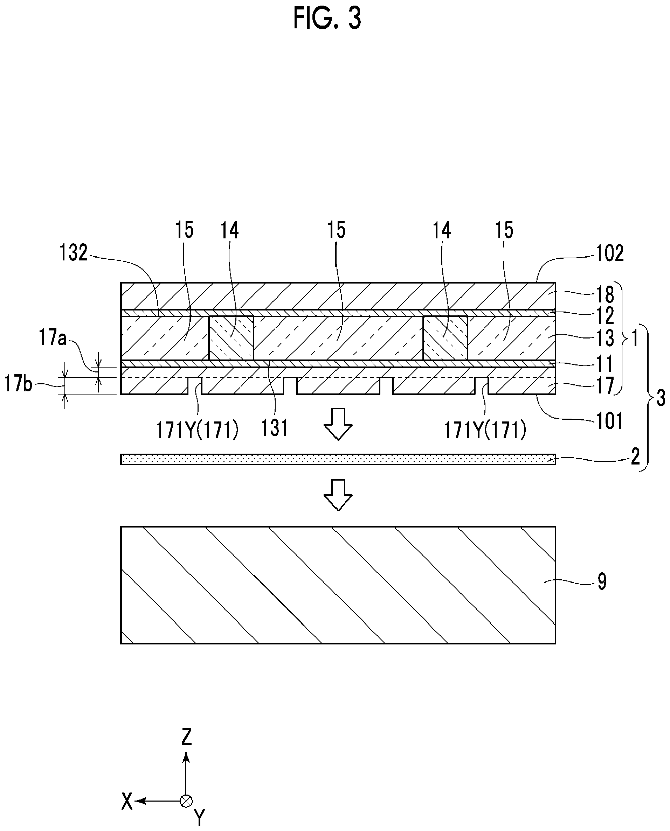

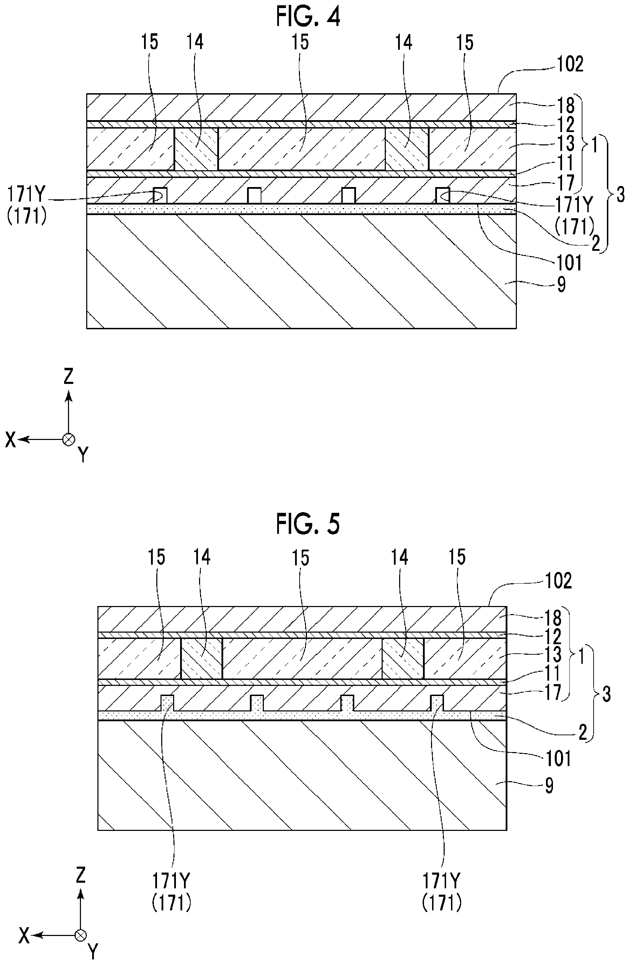

FIG. 1 is a plan view illustrating an optical waveguide according to a first embodiment. FIG. 2 is a partially enlarged perspective view of the optical waveguide illustrated in FIG. 1. FIG. 3 is a cross-sectional view taken along line A-A of the optical waveguide illustrated in FIG. 1 and a diagram for explaining a method of using the optical waveguide. FIGS. 4 and 5 are diagrams illustrating a state in which the optical waveguide is stuck to an adhesion target by a use method illustrated in FIG. 3, respectively. In FIG. 1, each layer of the optical waveguide in which a plurality of layers are stacked is seen through. In the following description, for convenience of explanation, the lower portion in FIG. 3 is referred to as "down" and the upper portion is referred to as "up".

According to the present embodiment, an optical waveguide 1 is a stacked body in a form of a sheet, in which a first cover layer 17, a clad layer 11, a core layer 13, a clad layer 12, and a second cover layer 18 are stacked in this order from the lower side of FIG. 2. As illustrated in FIG. 1, four elongated core portions 14 and side clad portions 15 provided adjacent to the side surfaces of the core portions 14 are formed in the core layer 13 among the above layers. In each drawing of the present application, a surface on which the optical waveguide 1 having a sheet shape expands is set as an X-Y plane, a core axis in which the core portion 14 extends is defined is set as a Y axis, an axis perpendicular to the Y axis is set as an X axis, and an axis perpendicular to both the X axis and the Y axis is set as a Z axis.

The plan-view shape of the optical waveguide 1 is not particularly limited, and may be a polygon such as a square or a hexagon, a circle such as a perfect circle, an ellipse, or an oval, or any other shape. In FIG. 1, a rectangle is used as the plan-view shape of the optical waveguide. The end surfaces of the core portion 14 are exposed to the side surfaces of the above-described core layer 13, which correspond to the two short sides parallel to the X axis.

As illustrated in FIG. 3, such an optical waveguide 1 is used to adhere to an adhesion target 9 by using the lower surface of the first cover layer 17 as an adhesive surface 101. An adhesive layer 2 is interposed between the adhesive surface 101 and the adhesion target 9. The optical waveguide 1 can be adhered to the adhesion target 9 by using the adhesiveness of the adhesive layer 2. The upper surface of the second cover layer 18 is set as an opposite surface 102.

Here, the optical waveguide 1 according to the present embodiment has a first recess portion 171 that is open to the adhesive surface 101. By providing such a first recess portion 171 in the optical waveguide 1, the mechanical strength of the first cover layer 17 is decreased in a portion in which the first recess portion 171 is provided. Therefore, when the first cover layer 17 is bent in a thickness direction of the first cover layer, it is possible to reduce the bending rigidity. Thus, the entire optical waveguide 1 can be easily bent in the thickness direction. As a result, when the optical waveguide 1 is stuck to the adhesion target 9 in a manner as illustrated in FIG. 3, for example, it is possible to improve the shape followability of the optical waveguide 1. Thus, a gap, peeling, and the like occur less frequently between the optical waveguide 1 and the adhesion target 9, and it is possible to improve the adhesive strength.

Each portion of the optical waveguide 1 will be described below in more detail.

### 1.1 Core Layer

As illustrated in FIG. 2, the side surface of the core portion 14 formed in the core layer 13 illustrated in FIG. 1 is surrounded by the side clad portion 15 and the clad layers 11 and 12. The refractive index of the core portion 14 is higher than the refractive indices of the side clad portion 15 and the clad layers 11 and 12. Thus, it is possible to cause light to be confined and propagate in the core portion 14.

In the core layer 13, the refractive index distribution in a plane perpendicular to an optical path of the core portion 14 may be any distribution. For example, so-called step index (SI) type distribution in which the refractive index changes discontinuously, or so-called graded index (GI) type distribution in which the refractive index changes continuously may be provided.

The cross-sectional shape of the core portion 14 by the plane perpendicular to the optical path of the core portion 14 is not particularly limited. The cross-sectional shape of the core portion 14 may be a circle such as a perfect circle, an ellipse, an oval, a polygon such as a triangle, a quadrangle, a pentagon, and a hexagon, and other irregular shapes.

The average thickness of the core layer 13 is not particularly limited, but is preferably about 1 to 200 µm, more preferably about 5 to 100 µm, and further preferably about 10 to 70 µm. Thus, the optical properties and the mechanical strength required for the core portion 14 are ensured.

Examples of the constituent material (main material) of the core layer 13 include various resin materials, for example, acrylic resins, methacrylic resins, polycarbonate, polystyrene, cyclic ether resins such as epoxy resins and oxetane resins, polyamide, polyimide, polybenzoxazole, polysilane, polysilazane, silicone resins, fluorine resins, polyurethane, polyolefin resins, polybutadiene, polyisoprene, polychloroprene, polyester such as PET and PBT, polyethylene succinate, polysulfone, polyether, and cyclic olefin resins such as benzocyclobutene resins and norbornene resins. As the resin material, a composite material in which materials having different compositions are combined is also used. In the present specification, the "main material" refers to a material that occupies 50% by mass or more of the constituent material, and preferably a material that occupies 70% by mass or more.

### 1.2 Clad Layer

The average thickness of each of the clad layers 11 and 12 is preferably about 1 to 200 µm, more preferably about 3 to 100 µm, and further preferably about 5 to 60 µm. Thus, the optical properties and the mechanical strength required for the clad layers 11 and 12 are ensured.

As the main materials of the clad layers 11 and 12, for example, the same material as the constituent material of the core layer 13 described above can be used.

The clad layers 11 and 12 may be provided as needed or may be omitted. At this time, for example, if the core layer 13 is exposed to the outside air (air), the outside air functions as the clad layers 11 and 12.

The optical waveguide 1 according to the present embodiment has the clad layer (first clad layer) 11 provided between the core layer 13 and the first cover layer 17, and the clad layer (second clad layer) 12 provided between the core layer 13 and the second cover layer 18.

By providing such clad layers 11 and 12, a refractive index difference stably occurs between the core portion 14 and the outside of the core portion, and thus it is possible to maintain the refractive index difference. Therefore, it is possible to more improve the transmission efficiency of the core portion 14.

Either or both of the clad layers 11 and 12 may be integrated with the side clad portion 15 in the core layer 13 described above.

### 1.3 Cover Layer

In the optical waveguide 1 illustrated in FIG. 3, the core layer 13 has a first surface 131 and a second surface 132 having a front and back relationship with each other. The first cover layer 17 is provided on the first surface 131 with the clad layer 11 interposed between the first cover layer and the first surface. The second cover layer 18 is provided on the second surface 132 with the clad layer 12 interposed between the second cover layer and the second surface. By providing such a first cover layer 17 and a second cover layer 18, it is possible to protect the core layer 13 and the clad layers 11 and 12, and to suppress a decrease in transmission efficiency of the core portion 14 due to an external environment or the like. In addition, in this specification, "being provided on the surface" refers to both a state of being provided directly on the surface and a state of being indirectly provided via an inclusion.

The average thickness of the first cover layer 17 and the second cover layer 18 is not particularly limited, but is preferably about 1 to 200 µm, more preferably about 3 to 100 µm, and further preferably about 5 to 50 µm.

The first cover layer 17 and the second cover layer 18 may have the same configuration or different configurations from each other. For example, the first cover layer 17 and the second cover layer 18 may have the same average thickness or different average thicknesses. The second cover layer 18 in the present embodiment may be provided as needed or may be omitted.

Examples of the main materials of the first cover layer 17 and the second cover layer 18 include materials containing various resins, for example, polyethylene terephthalate (PET), polyethylene naphthalate (PEN), polyethylene, polyolefins such as polypropylene, polyimide, and polyamide.

Among the above materials, the main materials of the first cover layer 17 and the second cover layer 18 are preferably polyimide resins, respectively. Since the polyimide resin has a relatively high elastic modulus and a high thermal decomposition temperature, the polyimide resin has sufficient durability against an external force and the external environment.

If necessary, fillers, antioxidants, UV absorbers, colorants, storage stabilizers, plasticizers, lubricants, anti-deterioration agents, antistatic agents, and the like may be added to the constituent materials of the first cover layer 17 and the second cover layer 18. By adding a filler among the additives, it is possible to adjust the thermal expansion coefficients of the first cover layer 17 and the second cover layer 18.

The tensile strength of the first cover layer 17 and the second cover layer 18 is preferably about 200 to 800 MPa, and more preferably about 250 to 750 MPa. By setting the tensile strength of the first cover layer 17 and the second cover layer 18 within the above range, it is possible to obtain the optical waveguide 1 having sufficient durability.

The tensile strength of the first cover layer 17 and the second cover layer 18 is measured in accordance with the test method of tensile properties defined in JIS K 7127: 1999 (ASTM D882). The tensile strength has a value measured at 25°C for a test piece having an average thickness of 25 µm.

The elastic moduli of the first cover layer 17 and the second cover layer 18 are preferably about 3000 to 12000 MPa, and more preferably about 4000 to 11000 MPa. By setting the elastic moduli of the first cover layer 17 and the second cover layer 18 within the above range, it is possible to sufficiently ensure the mechanical strength of the first cover layer 17 even though the first recess portion 171 is formed in the first cover layer 17. Thus, it is possible to achieve both the improvement in bendability due to the provision of the first recess portion 171 and the protection ability of the core portion 14 and the like based on the mechanical strength of the first cover layer 17. In addition, similar to the first cover layer 17, it is possible to obtain the effects similar to the above description even when a recess portion is formed in the second cover layer 18 as described later.

The elastic moduli of the first cover layer 17 and the second cover layer 18 are measured in accordance with the test method of tensile properties defined in JIS K 7127: 1999 (ASTM D882). The tensile strength has a value measured at 25°C for a test piece having an average thickness of 25 µm.

The elastic moduli of the first cover layer 17 and the second cover layer 18 are preferably greater than the elastic modulus of the core layer 13. By setting such a difference in elastic modulus, it is possible to more improve the ability of protecting the core layer 13, by the first cover layer 17 and the second cover layer 18. As a result, even though a load is applied to the optical waveguide 1, the decrease of the transmission efficiency occurs less frequently. Thus, it is possible to improve the reliability.

The difference between the elastic moduli of the first cover layer 17 and the second cover layer 18 and the elastic modulus of the core layer 13 is not particularly limited, but is preferably 50 MPa or more, more preferably 100 MPa or more and 1000 MPa or less. By setting the difference in elastic modulus within the above range, it is possible to sufficiently improve the protection ability without impairing the flexibility of the optical waveguide 1.

In this comparison, the elastic moduli of the first cover layer 17, the second cover layer 18, and the core layer 13 are measured by a measuring method as follows.

First, a test piece is prepared from the constituent materials of the first cover layer 17, the second cover layer 18, and the core layer 13. The size of the test piece is 20 mm in length, 5 mm in width, and 0.025 mm in thickness. This test piece is set in a dynamic viscoelasticity measuring device, and the storage elastic modulus E' is measured under conditions of a measurement temperature of 20°C to 200°C, a tensile mode, a frequency of 10 Hz, and an automatic static load. The measurement result at 50°C in this state is set as the elastic modulus of each portion.

The thermal expansion coefficients of the first cover layer 17 and the second cover layer 18 are not particularly limited, but the linear expansion coefficients are preferably about 5 to 25 ppm/°C, and more preferably about 7 to 20 ppm/°C. Thus, it is possible to obtain the optical waveguide 1 having relatively small thermal deformation.

Preferably, the thermal expansion coefficient of the first cover layer 17 is substantially equal to the thermal expansion coefficient of the second cover layer 18. Being substantially equal means that the difference between the thermal expansion coefficients of the first cover layer 17 and the second cover layer 18 is 2 ppm/°C or less. Thus, the difference in thermal expansion between the first cover layer 17 and the second cover layer 18 is particularly unlikely to occur, so that the warp of the optical waveguide 1 is suppressed, and it is possible to suppress peeling of the optical waveguide 1 after adhering, off from the adhesion target 9 due to this warp.

### 1.4 Recess Portion

As illustrated in FIGS. 2 and 3, the optical waveguide 1 has the first recess portion 171 that is open to the adhesive surface 101. As illustrated in FIG. 1, the first recess portion 171 includes a plurality of first recess portions 171X and a plurality of first recess portions 171Y. The first recess portions 171X extend along the X-axis and are arranged along the Y-axis. The first recess portions 171Y extend along the Y-axis and are arranged along the X-axis. The plurality of first recess portions 171X intersect with the plurality of first recess portions 171Y. Thus, the first recess portion 171 has a grid pattern when the adhesive surface 101 is viewed in a plan view.

By providing such a first recess portion 171 in the first cover layer 17, the mechanical strength is decreased in a portion in which the first recess portion 171 is provided in the first cover layer 17. Therefore, when the first cover layer 17 is bent in a thickness direction of the first cover layer, it is possible to reduce the bending rigidity. Thus, when the optical waveguide 1 is stuck to the adhesion target 9 in a manner as illustrated in FIG. 3, for example, it is possible to improve the shape followability of the optical waveguide 1. Therefore, a gap, peeling, and the like occur less frequently between the optical waveguide 1 and the adhesion target 9, and it is possible to improve the adhesive strength.

The first recess portion 171X according to the present embodiment is a first groove extending along the X axis (first axis). Similarly, the first recess portion 171Y is a second groove extending along the Y axis (second axis) . Since the first recess portion 171 is a groove as described above, it is possible to particularly reduce the bending rigidity when the optical waveguide 1 is bent in a direction perpendicular to the grooves. Accordingly, as in the present embodiment, by providing the first recess portions 171X and the first recess portions 171Y that intersect each other, it is possible to improve the isotropic property of the bendability, and to realize the optical waveguide 1 having excellent shape followability regardless of the shape of the adhesion target 9.

In the present embodiment, the first recess portion 171Y being the second groove is parallel to the core axis on which the core portion 14 extends, but the first recess portion 171Y may not be parallel to the core axis. Similarly, the first recess portion 171X being the first groove is perpendicular to the core axis on which the core portion 14 extends, but the first recess portion 171X and the core axis may intersect with each other at an angle other than a right angle. An intersection angle between the X axis along which the first recess portion 171X is and the core axis along which the core portion 14 is, in FIG. 1, is 90°, but the intersection angle is not limited to 90°. The intersection angle may be, for example, 10° to 90°, and preferably be 60° to 90°. As long as the intersection angle between the first recess portion (first groove) 171X and the core axis is within the above range, it is possible to realize the optical waveguide 1 having excellent shape followability at any intersection angle.

Further, an intersection angle between the first recess portion 171X and the first recess portion 171Y in FIG. 1 is 90°, but the intersection angle is not limited to 90°. The intersection angle may be, for example, 10° to 90°, and preferably be 60° to 90°. As long as the intersection angle is within this range, it is possible to sufficiently ensure the isotropic property of bendability and to realize the optical waveguide 1 having sufficiently-improved shape followability.

Further, in a case where the adhesive layer 2 before curing is formed of a solid or semi-solid adhesive sheet, there is a high possibility that the adhesive layer 2 is cured with hardly entering to the first recess portion 171 as illustrated in FIG. 4. If the adhesive layer 2 is cured with hardly entering to the first recess portion 171, a space by the first recess portion 171 remains between the optical waveguide 1 and the adhesive layer 2. In other words, in an optical waveguide 3 with an adhesive layer described later, the first recess portion 171 forms a cavity. Such a space act to reduce the average elastic modulus of a portion 17b in which the first recess portion 171 is provided in the entire thickness of the first cover layer 17, in comparison to a portion 17a in which the first recess portion 171 is not provided. That is, by providing the first recess portion 171, it is possible to lower the average value of the elastic modulus of the portion 17b from the elastic modulus of the material. This enables the portion 17b to act like a buffer layer that relieves stress. As a result, for example, even in a case where there is a large difference in thermal expansion coefficient between the optical waveguide 1 and the adhesion target 9, it is possible to relieve the thermal stress based on the difference, by the portion 17b. Thus, it is possible to suppress a decrease in the transmission efficiency of the core portion 14 due to the thermal stress.

In a case where the adhesive layer 2 before curing, which is used to adhere the optical waveguide 1 to the adhesion target 9 is formed of a liquid adhesive, there is a high possibility that the adhesive layer 2 is cured with entering to the first recess portion 171 as illustrated in FIG. 5. If the adhesive layer 2 is cured with entering to the first recess portion 171, it is possible to enhance the adhesive force between the optical waveguide 1 and the adhesion target 9, by the anchor effect. In addition, if the liquid adhesive enters to the first recess portion 171, the liquid adhesive easily permeates into the first recess portion 171 by the capillary phenomenon. Thus, there is an advantage that unevenness of the adhesive occurs less frequently.

The adhesive layer 2 formed from an adhesive sheet may enter to the first recess portion 171, and the adhesive layer 2 formed from a liquid adhesive may not enter to the first recess portion 171.

In a case where the first recess portion 171 is a groove, when the optical waveguide 1 is adhered to the adhesion target 9, it is possible to remove the air remaining between the adhesive surface 101 and the adhesive layer 2, through the groove. Therefore, air bubbles are less likely to be generated between the adhesive surface 101 and the adhesive layer 2, and it is possible to suppress the decrease in adhesive strength due to the air bubbles.

As described above, the optical waveguide 1 according to the present embodiment includes the core layer 13 that has the first surface 131 and the second surface 132 having a front and back relationship with each other, and includes the core portion 14 extending along the Y axis (core axis) and the side clad portion 15, the first cover layer 17 that is provided on the first surface 131 and has the adhesive surface 101 on an opposite side of the core layer 13, and the second cover layer 18 that is provided on the second surface 132 and has the opposite surface 102 on an opposite side of the core layer 13. The optical waveguide 1 has a sheet shape and has the first recess portion 171 that is open to the adhesive surface 101. Such an optical waveguide 1 is used by being adhered to the adhesion target 9 via the adhesive layer 2 in contact with the adhesive surface 101.

Such an optical waveguide 1 has a feature that it is easy to follow the shape of the adhesion target 9 when the optical waveguide 1 is used by being stuck to the adhesion target 9 in the above-described manner. Therefore, gaps, peeling, and the like occur less frequently between the optical waveguide 1 and the adhesion target 9 at the time of sticking or after sticking. As a result, it is possible to improve the adhesive strength. In particular, the optical waveguide 1 is useful in that the optical waveguide 1 can easily follow the shape of the adhesion target 9 even in a case where the surface of the adhesion target 9 includes a curved surface.

The shape of the first recess portion 171 when the adhesive surface 101 is viewed in a plan view may be an isotropic shape, for example, a square or a perfect circle. In FIG. 1, the shape of the first recess portion 171 is a line shape having large anisotropy. That is, the first recess portion 171 includes the first recess portion (first groove) 171X extending along the X axis (first axis) and the first recess portion (second groove) 171Y extending along the Y axis (second axis) that intersects with the X axis. Since the first recess portion 171 includes such a groove, it is possible to particularly reduce the bending rigidity when the optical waveguide 1 is bent in the thickness direction. In addition, since the first recess portion 171 includes the groove, the air can be easily removed through the first recess portion 171. Thus, there is an advantage that air bubbles are less likely to remain between the adhesive surface 101 and the adhesive layer 2. Further, as long as the optical waveguide has such a shape, it is possible to relatively easily form the first recess portion 171 by a mechanical method such as a dicing blade. Thus, the first recess portion 171 including the first recess portion 171X and the first recess portion 171Y is also useful in this point.

In addition, since the first recess portion 171 includes both the first recess portion 171X and the first recess portion 171Y that intersect with each other, it is possible to improve the isotropic property of the bendability and to realize the optical waveguide 1 having excellent shape followability regardless of the shape of the adhesion target 9.

Either the first recess portion 171X or the first recess portion 171Y in the first recess portion 171 may be omitted.

The bottom of the first recess portion 171 illustrated in FIG. 3 is located in the first cover layer 17. In other words, the first recess portion 171 does not penetrate the first cover layer 17. Thus, the function of the first cover layer 17 that protects the core layer 13 and the clad layers 11 and 12 is less likely to be impaired. Therefore, it is possible to realize the optical waveguide 1 having high reliability while ensuring the bendability.

The first recess portion 171 includes the plurality of first recess portions 171X, and the depths of the first recess portions 171X may be equal to or different from each other. Similarly, the first recess portion 171 includes the plurality of first recess portions 171Y, and the depths of the first recess portions 171Y may be equal to or different from each other. The depths of the first recess portions 171X and the depths of the first recess portions 171Y may be equal to or different from each other.

The depth of the first recess portion 171, that is, the thickness of the portion 17b is not particularly limited as long as the thickness of the portion 17b is less than the thickness of the first cover layer 17. The thickness of the portion 17b is preferably 1% to 90% of the thickness of the first cover layer 17, more preferably 20% to 80%, and further preferably 40% to 75%. By setting the depth of the first recess portion 171 within the above range, it is possible to achieve both the shape followability of the optical waveguide 1 and the protection ability of the first cover layer 17.

If the depth of the first recess portion 171 is less than the lower limit value, there is a concern that the first recess portion 171 becomes too shallow, and thus it is not possible to sufficiently improve the shape followability of the optical waveguide 1. On the other hand, if the depth of the first recess portion 171 is more than the upper limit value, there is a concern that the first recess portion 171 becomes too deep, and the thickness of the portion 17a becomes too thin. Therefore, there is a concern that, when a load is applied, the first recess portion 171 penetrates and further proceeds, and thus the protection ability is decreased.

The width WX of the first recess portion 171X and the width WY of the first recess portion 171Y are appropriately set in accordance with the thickness, the size, and the like of the optical waveguide 1, respectively. As an example, the width WX of the first recess portion 171X and the width WY of the first recess portion 171Y are preferably 50 µm to 5 mm, and more preferably 100 µm to 3 mm. Thus, it is possible to particularly improve the shape followability of the optical waveguide 1.

The width WX of the first recess portion 171X and the width WY of the first recess portion 171Y are preferably about 0.2 to 5.0 times the depth of the first recess portion 171, and more preferably about 0.5 to 3.0 times. Thus, it is possible to particularly improve the shape followability without reducing the mechanical strength of the first cover layer 17.

The pitch PX between the first recess portions 171X and the pitch PY between the first recess portions 171Y are appropriately set in accordance with the widths WX and WY, the thickness, the size, and the like of the optical waveguide 1, respectively. As an example, the pitch PX between the first recess portions 171X and the pitch PY between the first recess portions 171Y are preferably from 100 µm to 100 mm, and more preferably from 300 µm to 50 mm. Thus, it is possible to particularly improve the shape followability of the optical waveguide 1.

The plurality of first recess portions 171X may have the same width or different widths from each other. Similarly, the plurality of first recess portions 171Y may have the same width or different widths from each other. Further, the widths of the first recess portions 171X and the widths of the first recess portions 171Y may be the same or different from each other.

The depth or the width of each of the first recess portion 171X and the first recess portion 171Y may change in the middle of the first recess portion 171X or the first recess portion 171Y. Further, the pitch when the first recess portions 171X are arranged along the Y axis and the pitch when the first recess portions 171Y are arranged along the X axis may be uniform or may change in the middle. Further, both the first recess portion 171X and the first recess portion 171Y according to the present embodiment extend linearly. Such a line shape may be configured by only a curved line or may be configured by a straight line and a curved line.

The end portion of the first recess portion 171X in an extension direction illustrated in FIG. 1 is exposed to the end surface of the first cover layer 17, but may be located before the end surface. Similarly, the end portion of the first recess portion 171Y in an extension direction illustrated in FIG. 1 is located before the end surface of the first cover layer 17, but may be exposed to the end surface.

The cross-sectional shapes of the first recess portion 171X and the first recess portion 171Y are not particularly limited, and may be a quadrangle as illustrated in FIG. 1 or another shape, for example, a semicircle, a triangle, or a pentagon.

The first recess portion (first groove) 171X illustrated in FIG. 1 extends along the X axis (first axis), and the X axis intersects with the core axis (Y axis) when the adhesive surface 101 is viewed in a plan view. That is, the first recess portion 171X being the first groove is provided to intersect with the core portion 14 in a plan view. By adopting such an arrangement, it is possible to reduce the area where the first recess portion 171 and the core portion 14 overlap each other in a plan view. In a region where the first recess portion 171 and the core portion 14 overlap each other, when the adhesive layer 2 enters to the first recess portion 171, there is a concern that stress is generated around the first recess portion 171 depending on the composition, physical properties, and the like of the adhesive layer 2, and the transmission efficiency of the core portion 14 is decreased. On the other hand, in the present embodiment, it is possible to minimize such a concern by minimizing the area of this region. As a result, it is possible to more improve the reliability of the optical waveguide 1 after being adhered to the adhesion target 9.

The first recess portion (second groove) 171Y illustrated in FIG. 1 extends along the Y axis (second axis), and the Y axis is parallel to the core axis when the adhesive surface 101 is viewed in a plan view. The first recess portion 171Y is shifted from the core portion 14 not to overlap the core portion 14. If the first recess portion 171Y overlaps the core portion 14, a region in which the first recess portion 171Y overlaps the core portion 14 is generated over a long distance. Thus, there is a concern that, when stress is generated around the first recess portion 171Y, the transmission efficiency of the core portion 14 is decreased. On the other hand, in the present embodiment, it is possible to minimize such a concern by shifting the first recess portion 171Y and the core portion 14 from each other. As a result, it is possible to more improve the reliability of the optical waveguide 1 after being adhered to the adhesion target 9.

### 1.5 Adhesive Layer

The adhesive layer 2 illustrated in FIG. 3 may be interposed between the optical waveguide 1 and the adhesion target 9 when the optical waveguide 1 is adhered to the adhesion target 9. The adhesive layer 2 may be provided on the optical waveguide 1 side in advance. That is, an optical waveguide 3 with an adhesive layer can be constructed by the optical waveguide 1 and the uncured adhesive layer 2 provided on the adhesive surface 101.

As described above, the optical waveguide 3 with an adhesive layer according to the present embodiment has the optical waveguide 1 and the uncured adhesive layer 2, and thus can be easily stuck to any adhesion target 9. Thus, the optical waveguide 3 with an adhesive layer is useful in that handleability is high.

Examples of the adhesive forming the adhesive layer 2 include various hot melt adhesives, for example, polyester adhesives, modified olefin adhesives in addition to acrylic adhesives, urethane adhesives, silicone adhesives, epoxy adhesives.

The uncured adhesive layer 2 may be in a liquid state, may be solid or semi-solid, or may be in a state in which the curing reaction is partially progressing. The curing principle of the adhesive layer 2 may be thermosetting or photocurable.

The uncured adhesive layer 2 may be provided on the entirety of the adhesive surface 101 or may be provided on a portion of the adhesive surface 101.

The thickness of the adhesive layer 2 after curing is not particularly limited, but is preferably 1 to 100 µm, and more preferably 5 to 60 µm.

### 2. First Modification Example of First Embodiment

Next, an optical waveguide according to a first modification example of the first embodiment will be described.

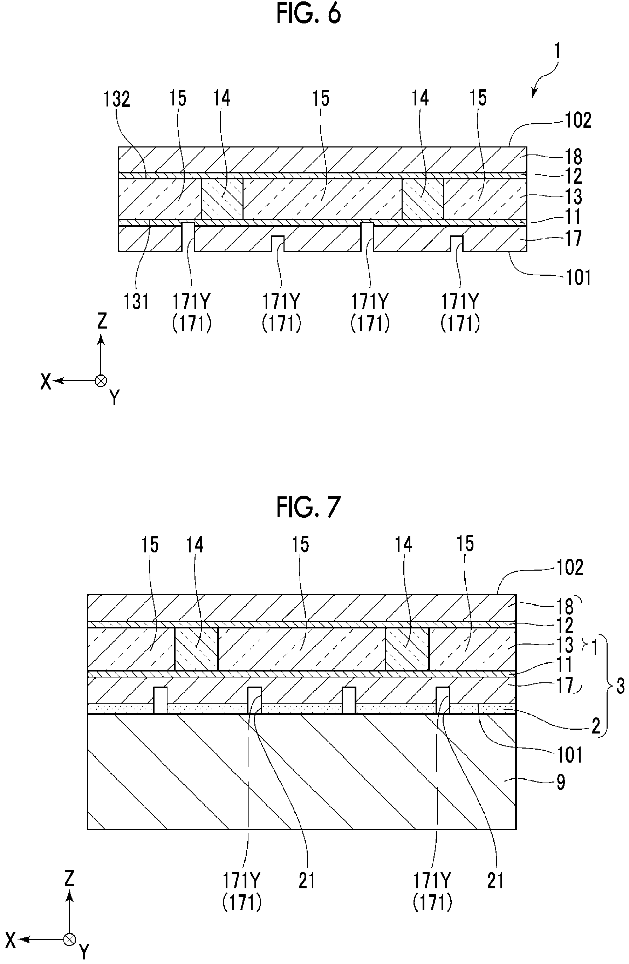

FIG. 6 is a cross-sectional view of the optical waveguide according to the first modification example of the first embodiment.

The first modification example of the first embodiment will be described below. The following description will be made focusing on differences from the first embodiment, and descriptions of the similar matters will be omitted. In FIG. 6, the similar components to those in the first embodiment are denoted by the similar reference signs to those described above, and detailed description thereof will be omitted.

The first modification example is similar to the first embodiment except that the configuration of the first recess portion 171 is different.

In FIG. 6, some of a plurality of first recess portions 171 penetrate the first cover layer 17. Thus, the bottoms of such first recess portions 171 are located in the clad layer 11.

As described above, some or all of the first recess portions 171 may penetrate the first cover layer 17. That is, the "recess portion" in the present application is a concept including a through-hole.

In the first modification example as described above, it is possible to obtain the similar effect to that of the first embodiment.

### 3. Second Modification Example of First Embodiment

Next, an optical waveguide with an adhesive layer according to a second modification example of the first embodiment will be described.

FIG. 7 is a cross-sectional view of the optical waveguide with an adhesive layer according to the second modification example of the first embodiment.

The second modification example of the first embodiment will be described below. The following description will be made focusing on differences from the first embodiment, and descriptions of the similar matters will be omitted. In FIG. 7, the similar components to those in the first embodiment are denoted by the similar reference signs to those described above, and detailed description thereof will be omitted.

The second modification example is similar to the first embodiment except that the configuration of the first recess portion 171 is different.

The adhesive layer 2 illustrated in FIG. 7 has a through-hole 21 provided at a position corresponding to the first recess portion 171. By providing such a through-hole 21, a space formed by connecting the first recess portion 171 and the through-hole 21 is formed between the optical waveguide 1 after adhesion and the adhesion target 9. Since such a space has a larger volume than that in FIG. 4, it is possible to enhance the function as a buffer layer for relieving stress by the increased volume.

In the second modification example as described above, it is possible to obtain the similar effect to that of the first embodiment.

### 4. Third Modification Example of First Embodiment

Next, an optical waveguide according to a third modification example of the first embodiment will be described.

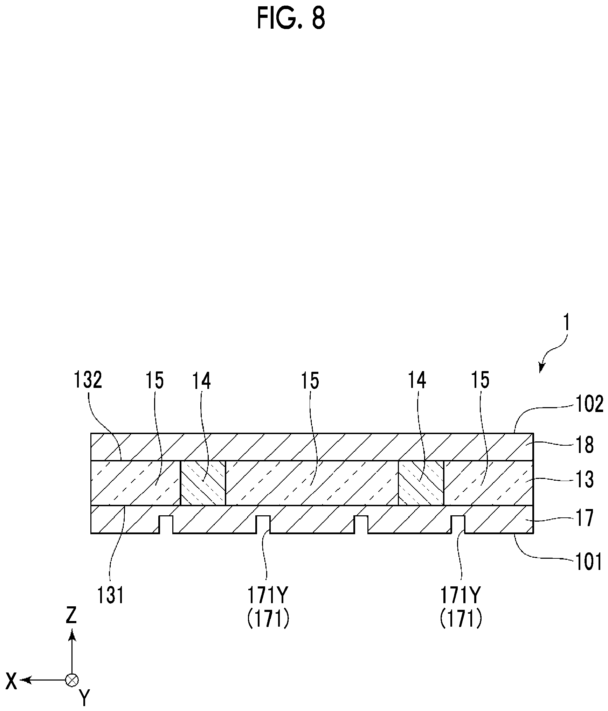

FIG. 8 is a cross-sectional view of the optical waveguide according to the third modification example of the first embodiment.

The third modification example of the first embodiment will be described below. The following description will be made focusing on differences from the first embodiment, and descriptions of the similar matters will be omitted. In FIG. 8, the similar components to those in the first embodiment are denoted by the similar reference signs to those described above, and detailed description thereof will be omitted.

The third modification example is similar to the first embodiment except that the configurations of the first cover layer 17 and the second cover layer 18 are different.

The optical waveguide 1 includes the clad layers 11 and 12 in the first embodiment described above, but the clad layers 11 and 12 are omitted in the third modification example. The first cover layer 17 has the function of the clad layer 11, and the second cover layer 18 has the function of the clad layer 12.

In the third modification example as described above, it is possible to obtain the similar effect to that of the first embodiment.

### 5. Fourth Modification Example of First Embodiment

Next, an optical waveguide according to a fourth modification example of the first embodiment will be described.

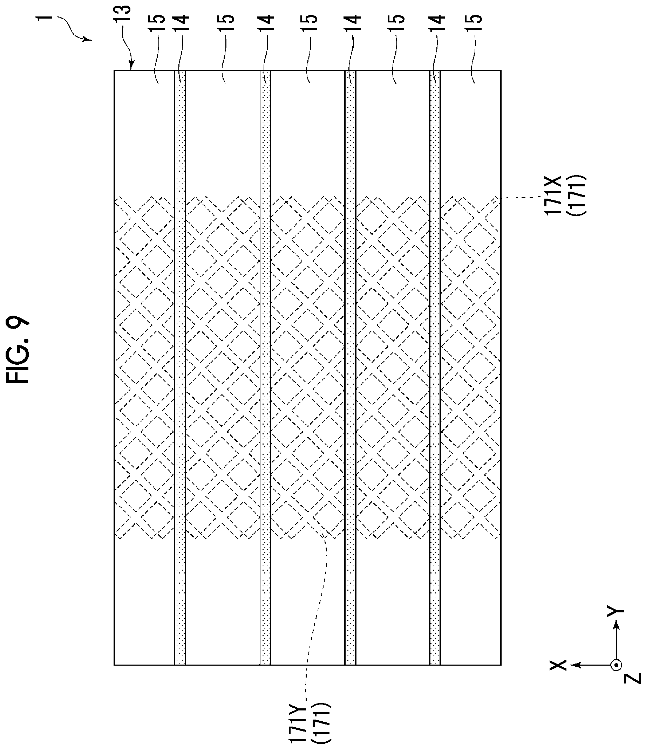

FIG. 9 is a cross-sectional view of the optical waveguide according to the fourth modification example of the first embodiment.

The fourth modification example of the first embodiment will be described below. The following description will be made focusing on differences from the first embodiment, and descriptions of the similar matters will be omitted. In FIG. 9, the similar components to those in the first embodiment are denoted by the similar reference signs to those described above, and detailed description thereof will be omitted.

The fourth modification example is similar to the first embodiment except that the configuration of the first recess portion 171 is different.

In the first embodiment described above, the first recess portion 171 includes the plurality of first recess portions 171X that extend along the X axis and are arranged along the Y axis, and the plurality of first recess portions 171Y that extend along the Y axis and are arranged along the X axis, and forms a grid pattern. On the other hand, in the fourth modification example, although the first recess portion 171 has a grid pattern, the first recess portion is rotated by 45° around the Z axis in comparison to the first embodiment. Thus, both the first recess portion 171X and the first recess portion 171Y intersect with the core portion 14 at an intersection angle of 45°. In addition, in the fourth modification example, although the first recess portion 171 has a grid pattern, the area in which the first recess portion 171 and the core portion 14 overlap each other is uniform regardless of the positional relationship between the first recess portion 171 and the core portion 14. Therefore, there is an advantage that the transmission efficiency of the core portion 14 is less likely to be uneven.

In the fourth modification example as described above, it is possible to obtain the similar effect to that of the first embodiment.

In the fourth modification example, the first recess portion 171 is rotated by 45° around the Z axis in comparison to the first embodiment, but the rotation angle is not particularly limited and may be any degree. As an example, if the rotation angle is about 10° to 80°, the fourth modification example is useful in that the above effect is easily obtained.

### 6. Fifth Modification Example of First Embodiment

Next, an optical waveguide according to a fifth modification example of the first embodiment will be described.

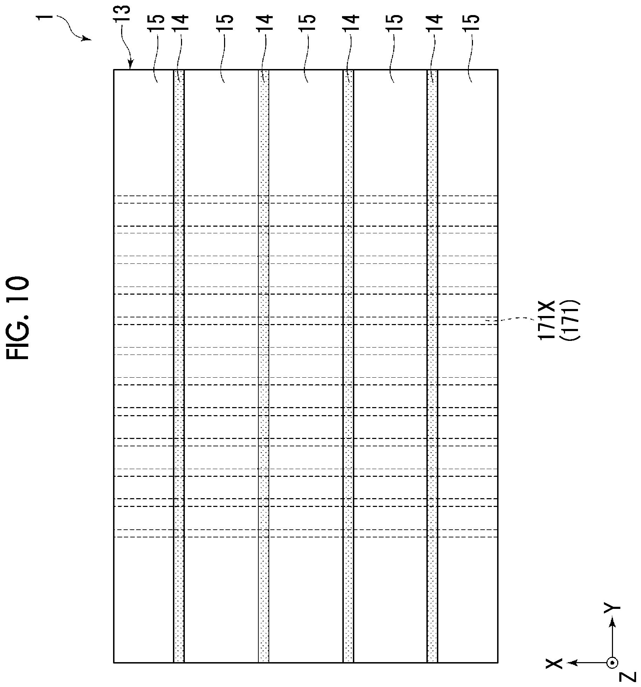

FIG. 10 is a cross-sectional view of the optical waveguide according to the fifth modification example of the first embodiment.

The fifth modification example of the first embodiment will be described below. The following description will be made focusing on differences from the first embodiment, and descriptions of the similar matters will be omitted. In FIG. 10, the similar components to those in the first embodiment are denoted by the similar reference signs to those described above, and detailed description thereof will be omitted.

The fifth modification example is similar to the first embodiment except that the configuration of the first recess portion 171 is different.

In the first embodiment described above, the first recess portion 171 includes the plurality of first recess portions 171X and the plurality of first recess portions 171Y, and forms a grid pattern. On the other hand, in the fifth modification example, the first recess portion 171 includes only a plurality of first recess portions 171X. In the fifth modification example, the area in which the first recess portion 171 and the core portion 14 overlap each other is uniform regardless of the positional relationship between the first recess portion 171 and the core portion 14. Therefore, there is an advantage that the transmission efficiency of the core portion 14 is less likely to be uneven.

In the fifth modification example as described above, it is possible to obtain the similar effect to that of the first embodiment.

### 7. Second Embodiment

Next, an optical waveguide according to a second embodiment will be described.

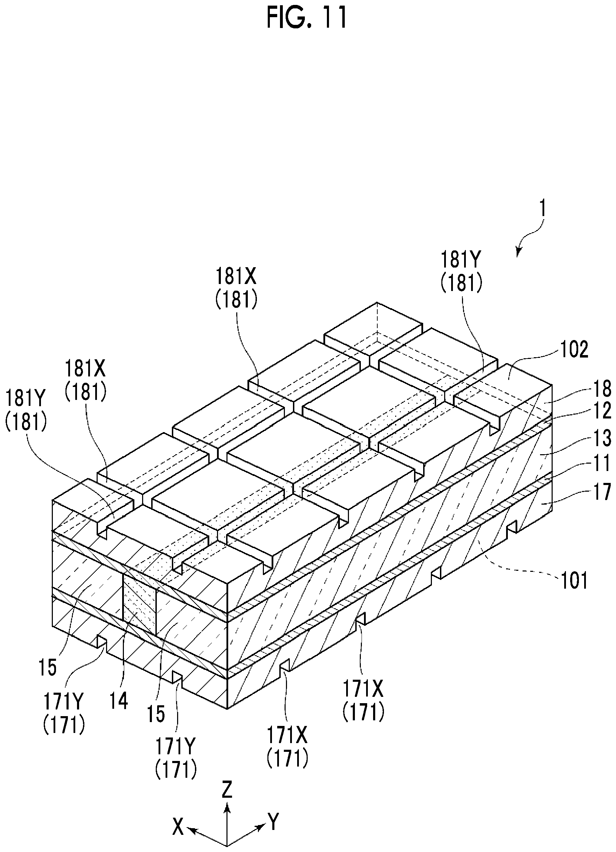

FIG. 11 is a partially enlarged perspective view of the optical waveguide according to the second embodiment.

The second embodiment will be described below. The following description will be made focusing on differences from the first embodiment, and descriptions of the similar matters will be omitted. In FIG. 11, the similar components to those in the first embodiment are denoted by the similar reference signs to those described above, and detailed description thereof will be omitted.

The second embodiment is similar to the first embodiment except that the second cover layer 18 includes a second recess portion 181.

The optical waveguide 1 illustrated in FIG. 11 includes the second recess portion 181 that is open to the opposite surface 102 being the upper surface of the second cover layer 18. That is, the optical waveguide 1 according to the present embodiment includes both the first recess portion 171 and the second recess portion 181. The second recess portion 181 includes a plurality of second recess portions 181Y that extend along the X-axis and are arranged along the Y-axis, and a plurality of second recess portions 181X that extend along the Y-axis and are arranged along the X-axis.

Such a second recess portion 181 is similar to the first recess portion 171 except that the forming position is different. By providing the second recess portion 181, it is possible to further improve the shape followability of the optical waveguide 1. Thus, for example, even in a case where the surface of the adhesion target 9 is wavy, it is possible to stick the optical waveguide 1 with a high close-adhesion property.

When the opposite surface 102 is viewed in a plan view, it is preferable that the first recess portion 171 and the second recess portion 181 overlap each other. Thus, it is possible to make the shape followability of the optical waveguide 1 equal between a case where the optical waveguide 1 is bent so that the first recess portion 171 is located inside and a case where the optical waveguide 1 is bent so that the second recess portion 181 is located inside. Thus, regardless of the surface shape of the adhesion target 9, it is possible to adhere the optical waveguide 1 closely and to suppress the occurrence of gaps peeling, and the like after adhesion.

Overlapping each other means a state where, in a case where the first recess portion 171 and the second recess portion 181 are grooves, the first recess portion 171 and the second recess portion 181 overlap each other in at least a portion of the width of the grooves.

It is preferable that the area occupied by the first recess portion 171 when the adhesive surface 101 is viewed in a plan view be equal to the area occupied by the second recess portion 181 when the opposite surface 102 is viewed in a plan view. Thus, it is possible to make the shape followability of the optical waveguide 1 equal between a case where the optical waveguide 1 is bent so that the first recess portion 171 is located inside and a case where the optical waveguide 1 is bent so that the second recess portion 181 is located inside.

Also in the second embodiment as described above, it is possible to obtain the similar effect to that of the first embodiment.

In addition, the configuration of the first recess portion 171 and the configuration of the second recess portion 181 may be the same or different from each other. For example, the width and depth of the first recess portion 171 may be equal to or different from the width and depth of the second recess portion 181.

### 8. Third Embodiment

Next, an optical waveguide according to a third embodiment will be described.

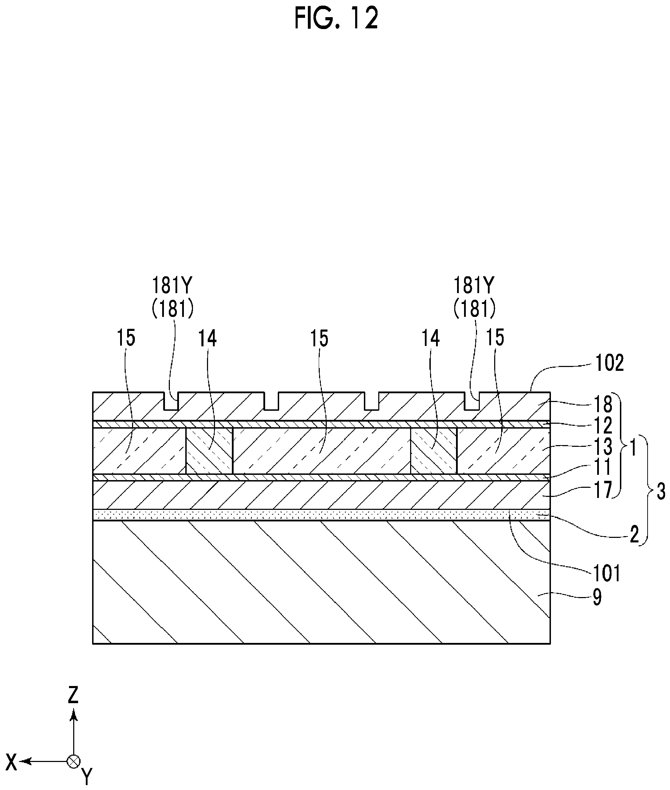

FIG. 12 is a cross-sectional view of an optical waveguide according to the third embodiment.

The third embodiment will be described below. The following description will be made focusing on differences from the second embodiment, and descriptions of the similar matters will be omitted. In FIG. 12, the similar components to those in the second embodiment are denoted by the similar reference signs to those described above, and detailed description thereof will be omitted.

The third embodiment is similar to the second embodiment except that the first recess portion 171 is omitted. Thus, the adhesive surface 101 illustrated in FIG. 12 is a flat surface without the first recess portion 171. On the other hand, the second cover layer 18 illustrated in FIG. 12 has a second recess portion 181 that is to the opposite surface 102. Even though the first recess portion 171 is omitted, the optical waveguide 1 has shape followability because the second recess portion 181 is provided.

Also in the third embodiment as described above, it is possible to obtain the similar effect to that of the second embodiment.

### 9. Optical Wiring Component

The optical waveguide 1 as described above constitutes an optical wiring component in combination with a component. That is, the optical wiring component according to the present embodiment includes the optical waveguide 1 and a component. Such an optical wiring component is used by being stuck to an adhesion target with a high close-adhesion property. Therefore, it is possible to realize an optical wiring component that is easy to be mounted. Examples of the above component include connectors, mirrors, lenses, and filters.

A connector is mounted at the end portion of the optical waveguide 1, and is responsible for connecting other optical components with the optical waveguide 1. The connector may have a shape based on the standard for optical connection. Examples of such a standard include MT.

A mirror may be provided in the optical waveguide 1 or may be provided outside the optical waveguide 1. In a case where the mirror is provided in the optical waveguide, it is possible to change an optical path propagating through the core portion 14 of the optical waveguide 1. When the mirror is provided outside the optical waveguide, it is possible to change an optical path of light incident to the optical waveguide 1 or an optical path of light emitted from the optical waveguide 1.

A lens may also be provided in the optical waveguide 1 or may be provided outside the optical waveguide. When the lens is provided in the optical waveguide, it is possible to converge or diverge light propagating in the core portion 14 of the optical waveguide 1. When the lens is provided outside the optical waveguide, it is possible to converge or diverge light incident to the optical waveguide 1 or light emitted from the optical waveguide 1.

A filter may also be provided in the optical waveguide 1 or may be provided outside the optical waveguide. When the filter is provided in the optical waveguide, it is possible to change the wavelength, the phase, and the like of the light propagating in the core portion 14 of the optical waveguide 1. When the filter is provided outside the optical waveguide, it is possible to change the wavelength, the phase, and the like of the light incident to the optical waveguide 1 or the light emitted from the optical waveguide 1.

### 10. Electronic Device

The optical waveguide 1 as described above can be stuck to the adhesion target 9 while suppressing the gap, and is less likely to cause problems such as peeling even after the sticking. Therefore, by including such an adhesion target 9, the optical waveguide 1, and the adhesive layer 2 provided between the adhesion target 9 and the adhesive surface 101 of the optical waveguide 1, it is possible to realize an electronic device having high reliability.

Examples of the electronic device include information and communication devices such as smartphones, tablet terminals, mobile phones, game machines, router devices, WDM devices, personal computers, televisions, servers, supercomputers, medical devices, sensor devices, instruments of vehicles, aircraft, and ships, automobile control devices, aircraft control devices, railroad vehicle control devices, ship control devices, spacecraft control devices, moving-object control devices such as rocket control devices, and plant control devices that control plants such as power plants, refineries, steel mills, and chemical complexes.

Hitherto, the optical waveguide, the optical waveguide with an adhesive layer, the optical wiring component, and the electronic device in the present invention have been described above based on the illustrated embodiments, but the present invention is not limited thereto.

For example, the optical waveguide with an adhesive layer may further include a protective layer that covers the adhesive layer. The protective layer is peeled off immediately before the optical waveguide with an adhesive layer is adhered to the adhesion target, so that it is possible to easily prepare a clean adhesive surface. As a result, it is possible to suppress the entrainment of foreign matters, and to perform adhesion with a higher close-adhesion property.

The line shape of the core portion is not particularly limited, and may be a straight line or may include a curved line.

### [Examples]

Next, specific examples of the present invention will be described.

### 11. Manufacturing of Adhered Body of Optical Waveguide and Adhesion Target

### (Example 1)

First, the optical waveguides illustrated in FIGS. 1 and 2 were prepared. Manufacturing conditions of the optical waveguide are as shown in Table 1. As the adhesive layer, an adhesive sheet formed of an epoxy adhesive was used.

Then, the optical waveguide was stuck to a glass adhesion target via the adhesive layer (adhesive sheet). The adhesion target is a glass plate having a concave curved surface, and the optical waveguide is stuck to the concave curved surface.

An adhered body of the optical waveguide and the adhesion target was obtained in the above-described manner.

In a plan view, the positions of the first recess portion provided in the first cover layer and the second recess portion provided in the second cover layer were set to overlap each other.

In a plan view, the positions of the recess portions extending along the Y-axis among the first recess portions and the second recess portions, and the position of the core portion are set not to overlap each other.

Further, in the present example, since the adhesive sheet was used, it was confirmed that a cavity was formed due to the recess portion.

### (Examples 2 and 3)

An adhered body was obtained in the similar manner to that in Example 1 except that the manufacturing conditions were changed as shown in Table 1.

### (Example 4)

An adhered body was obtained in the similar manner to that in Example 1 except that formation of the second recess portion was omitted.

### (Example 5)

An adhered body was obtained in the similar manner to that in Example 4 except that the groove extending along the Y axis was omitted from the first recess portion. If the groove extending along the Y axis is omitted from the first recess portion, only the groove extending along the X axis remains, so that the shape of the first recess portion in a plan view is striped.

### (Example 6)

An adhered body was obtained in the similar manner to that in Example 1 except that formation of the first recess portion was omitted.

### (Examples 7 and 8)

An adhered body was obtained in the similar manner to that in Example 1 except that the manufacturing conditions were changed as shown in Table 1.

### (Example 9)

An adhered body was obtained in the similar manner to that in Example 1 except that the positions of the first recess portion and the second recess portion were set not to overlap each other in a plan view.

### (Example 10)

An adhered body was obtained in the similar manner to that in Example 1 except that the positions of the first recess portion and the second recess portion and the position of the core portion were set to overlap each other in a plan view.

### (Example 11)

An adhered body was obtained in the similar manner to that in Example 1 except that a liquid adhesive was used instead of the adhesive sheet. Since the liquid adhesive was used, it was confirmed that the recess portion were filled with the adhesive.

### (Examples 12 to 18)

An adhered body was obtained in the similar manner to that in Example 1 except that the manufacturing conditions were changed as shown in Table 2.

### (Comparative example)

An adhered body was obtained in the similar manner to that in Example 1 except that both the first recess portion and the second recess portion were omitted.

### 12. Evaluation Results of Adhered Body

### 12.1 Evaluation of Close-adhesion Property

First, the adhered body was visually observed from the glass plate side. Then, it was confirmed whether peeling occurred between the adhesion target and the optical waveguide. In a case where peeling occurred, the area was measured.

Then, the total peeling area was calculated for each adhered body. When the total peeling area of the adhered body of the comparative example was set to 1, the relative value of the total peeling area of the adhered body in each example was calculated.

Then, the obtained relative values were evaluated based on evaluation criteria as follows.

### <Evaluation criteria for Close-adhesion Property>

A: The relative value of the peeling area is less than 0.50
B: The relative value of the peeling area is 0.50 or more and less than 0.75
C: The relative value of peeling area is 0.75 or more and less than 1.00
D: The relative value of peeling area is 1.00 or more

Tables 1 and 2 show the above evaluation results.

### 12.2 Evaluation of Transmission Loss

The obtained adhered body was subjected to a temperature cycle test (-10°C to 60°C, 500 cycles).

Then, for the adhered body after the test, the propagation loss was obtained in accordance with the 4.6.2.1 cutback method of "Test method for polymeric optical waveguide (JPCA-PE02-05-01S-2008)". Light having a wavelength of 850 nm was used for the measurement.

Then, the obtained propagation loss was evaluated based on evaluation criteria as follows.

### <Evaluation Criteria for Propagation Loss>

A: The propagation loss is small (less than 0.05 [dB/cm])
B: The propagation loss is slightly small (0.05 [dB/cm] or more and less than 0.1 [dB/cm])
C: The propagation loss is slightly large (0.1 [dB/cm] or more and less than 0.2 [dB/cm])
D: The propagation loss is large (0.2 [dB/cm] or more)

Tables 1 and 2 show the above evaluation results.

**[Table 1]**

| | | | | Example 1 | Example 2 | Example 3 | Example 4 | Example 5 | Example 6 | Example 7 | Example 8 | Example 9 | Example 10 | Example 11 | Comparative Example |
|---|---|---|---|---|---|---|---|---|---|---|---|---|---|---|---|
| Second cover layer | Thickness of second cover layer | | µm | 25 | 25 | 25 | 25 | 25 | 25 | 25 | 25 | 25 | 25 | 25 | 25 |
| | Depth of second recess portion | | µm | 20 | 20 | 20 | - | - | 20 | 20 | 20 | 20 | 20 | 20 | - |
| | portion Width of second recess portion | | µm | 15 | 15 | 15 | - | - | 15 | 15 | 15 | 15 | 15 | 15 | - |
| | portion Shape of second recess portion in plan view | | - | Grid pattern | Grid pattern | Grid pattern | None | None | Grid pattern | Grid pattern | Grid pattern | Grid pattern | Grid pattern | Grid pattern | None |
| | Pitch between secondaxis recess portions | X axis | mm | 0.5 | 0.5 | 0.5 | - | - | 0.5 | 1.0 | 2.0 | 0.5 | 0.5 | 0.5 | - |
| | | Y axis | mm | 0.5 | 0.5 | 0.5 | - | - | 0.5 | 1.0 | 1.0 2.0 | 0.5 | 0.5 | 0.5 | - |
| Core layer | Width of core layer axis | | µm | 48 | 72 | 24 | 48 | 48 | 48 | 48 | 48 | 48 | 48 | 48 | 48 |
| | Thickness of core layer | | µm | 42 | 63 | 21 | 42 | 42 | 42 | 42 | 42 | 42 | 42 | 42 | 42 |
| First cover layer | Thickness of first cover layer | | µm | 12.5 | 12.5 | 12.5 | 12.5 | 12.5 | 12.5 | 12.5 | 12.5 | 12.5 | 12.5 | 12.5 | 12.5 |
| | portion Depth of first recess portion | | µm | 7.5 | 7.5 | 7.5 | 7.5 | 7.5 | - | 7.2 | 7.5 | 7.5 | 7.5 | 7.5 | - |
| | portion Width of first recess portion | | µm | 15 | 15 | 15 | 15 | 15 | - | 15 | 15 | 15 | 15 | 15 | - |
| | portion Shape of first recess in view | | - | Grid pattern | Grid pattern | Grid pattern | Grid pattern | Striped | None | Grid pattern | Grid pattern | Grid pattern | Grid pattern | Grid pattern | None |
| | Pitch between firstaxis recess portions | X axis | mm | 0.5 | 0.5 | 0.5 | 0.5 | 0.5 | - | 1.0 | 2.0 | 0.5 | 0.5 | 0.5 | - |
| | | Y axis | mm | 0.5 | 0.5 | 0.5 | 0.5 | - | - | 1.0 | 2.0 | 0.5 | 0.5 | 0.5 | - |
| Positional relation between first recess portion and second recess portion in plan view | | | - | Overlap | Overlap | Overlap | - | - | - | Overlap | Overlap | No overlap | Overlap | Overlap | - |
| Positional relation between core portion and recess portion along Y axis in plan view | | | - | No overlap | No overlap | No overlap | No overlap | No overlap | No overlap | No overlap | No overlap | No overlap | Overlap | No overlap | - |
| Gap due to recess portion | | | - | Presence | Presence | Presence | Presence | Presence | None | Presence | Presence | Presence | Presence | None | None |
| Evaluation results | Close-adhesion property | | - | A | A | A | B | C | B | A | B | B | A | A | D |
| | Transmission loss | | - | A | A | A | A | B | C | A | A | A | B | C | D |

**[Table 2]**

| | | | | Example 12 | Example 13 | Example 14 | Example 15 | Example 16 | Example 17 | Example 18 |
|---|---|---|---|---|---|---|---|---|---|---|
| Second cover layer | Thickness of second cover layer | | µm | 25 | 25 | 25 | 25 | 25 | 25 | 25 |
| | Depth of second recess portion | | µm | 20 | 20 | 20 | 15 | 20 | 20 | 20 |
| | Width of second recess portion | | µm | 5 | 30 | 120 | 15 | 15 | 5 | 15 |
| | Shape of second recess portion in plan view | | - | Grid pattern | Grid pattern | Grid pattern | Grid pattern | Grid pattern | Grid pattern | Striped |
| | Pitch between second recess portions | X axis | mm | 0.5 | 0.5 | 0.5 | 0.5 | 0.5 | 0.5 | 0.5 |
| | | Y axis | mm | 0.5 | 0.5 | 0.5 | 0.5 | 0.5 | 0.5 | - |
| Core layer | Width of core laver | | µm | 48 | 48 | 48 | 48 | 48 | 48 | 48 |
| | Thickness of core layer | | µm | 42 | 42 | 42 | 42 | 42 | 42 | 42 |
| First cover layer | Thickness of first cover laver | | µm | 12.5 | 12.5 | 12.5 | 12.5 | 25 | 12.5 | 12.5 |
| | Depth of first recess portion | | µm | 7.5 | 7.5 | 7.5 | 2.5 | 20 | 7.5 | 7.5 |
| | Width of first recess portion | | µm | 5 | 30 | 120 | 15 | 15 | 15 | 5 |
| | Shape of first recess portion in plan view | | - | Grid pattern | Grid pattern | Grid pattern | Grid pattern | Grid pattern | Grid pattern | Grid pattern |
| | Pitch between first recess portions | X axis | mm | 0.5 | 0.5 | 0.5 | 0.5 | 0.5 | 0.5 | 0.5 |
| | | Y axis | mm | 0.5 | 0.5 | 0.5 | 0.5 | 0.5 | 0.5 | 0.5 |
| Positional relation between first recess portion and second recess portion in plan view | | | - | Overlap | Overlap | Overlap | Overlap | Overlap | Overlap | Overlap |
| Positional relation between core portion and recess portion along Y axis in plan view | | | - | No overlap | No overlap | No overlap | No overlap | No overlap | No overlap | No overlap |
| Gap due to recess portion | | | - | Presence | Presence | Presence | Presence | Presence | Presence | Presence |
| Evaluation results | Close-adhesion property | | - | B | A | B | B | A | B | B |
| | Transmission loss | | - | A | A | B | A | A | A | A |

As shown in Tables 1 and 2, the adhered body obtained in each example had a high close-adhesion property between the optical waveguide and the adhesion target.

In addition, in the adhered body obtained in each example, a state in which the transmission loss was small was maintained even after the temperature cycle test was performed. In particular, in a case where there was a cavity due to the recess portion, this tendency was remarkable.

### Industrial Applicability

According to the present invention, the optical waveguide is used by being adhered to an adhesion target via an adhesive layer. The optical waveguide includes a core layer that has a first surface and a second surface having a front and back relationship with each other, and includes a core portion extending along a core axis, a first cover layer that is provided on the first surface, and has an adhesive surface on an opposite side of the core layer, and a second cover layer that is provided on the second surface, and has an opposite surface on an opposite side of the core layer. A first recess portion including a first groove extending along a first axis that intersects with the core axis is provided on the adhesive surface of the first cover layer in a plan view. By providing such a first recess portion in the first cover layer, the mechanical strength is decreased in a portion in which the first recess portion is provided in the first cover layer. Therefore, when the first cover layer is bent in a thickness direction of the first cover layer, it is possible to reduce the bending rigidity. Thus, when the optical waveguide is stuck to the adhesion target, it is possible to improve the shape followability of the optical waveguide. Therefore, a gap, peeling, and the like occur less frequently between the optical waveguide and the adhesion target, and it is possible to improve the adhesive strength. Accordingly, the present invention has industrial applicability.

## Claims

1. An optical waveguide comprising:
a core layer having a first surface and a second surface having a front and back relationship with each other, the core layer including a core portion extending along a core axis and a side clad portion;
a first cover layer provided on the first surface, the first cover layer having an adhesive surface on an opposite side of the core layer; and
a second cover layer provided on the second surface, the second cover layer having an opposite surface on an opposite side of the core layer,
wherein the optical waveguide has a sheet shape and has a first recess portion that is open to the adhesive surface,
when the adhesive surface is viewed in plan view, the first recess portion includes a first groove extending along a first axis that intersects with the core axis, and
the optical waveguide is used by being adhered to an adhesion target via an adhesive layer in contact with the adhesive surface.

2. The optical waveguide according to claim 1, wherein a bottom of the first recess portion is located in the first cover layer.

3. The optical waveguide according to claim 1 or 2, wherein
a depth of the first groove is 20% to 80% of a thickness of the first cover layer.

4. The optical waveguide according to claim 3, wherein a width of the first groove is 0.2 to 5.0 times the depth of the first groove.

5. The optical waveguide according to any one of claims 1 to 4, wherein
when the adhesive surface is viewed in the plan view, the first recess portion further includes a second groove extending along a second axis that intersects with the first axis.

6. The optical waveguide according to any one of claims 1 to 5, further comprising:
a second recess portion that is open to the opposite surface of the second cover layer.

7. The optical waveguide according to any one of claims 1 to 6, wherein
elastic moduli of the first cover layer and the second cover layer are greater than an elastic modulus of the core layer.

8. The optical waveguide according to any one of claims 1 to 7, further comprising:
a first clad layer provided between the core layer and the first cover layer; and
a second clad layer provided between the core layer and the second cover layer.

9. An optical waveguide with an adhesive layer, the optical waveguide comprising:
the optical waveguide according to any one of claims 1 to 8; and
an uncured adhesive layer provided on the adhesive surface of the optical waveguide.

10. The optical waveguide with an adhesive layer according to claim 9, wherein
the first recess portion of the optical waveguide forms a cavity.

11. An optical wiring component comprising:
the optical waveguide according to any one of claims 1 to 8 .

12. An electronic device comprising:
an adhesion target;
the optical waveguide according to any one of claims 1 to 8; and
an adhesive layer provided between the adhesion target and the adhesive surface of the optical waveguide.
